Europäisches Patentamt

European Patent Office

Office européen des brevets

(19)

(11) Veröffentlichungsnummer: **0 003 237**
**B1**

(12) **EUROPÄISCHE PATENTSCHRIFT**

(45) Veröffentlichungstag der Patentschrift: **18.05.83**

(51) Int. Cl.³: **H 01 L 31/02, C 22 C 29/00**

(21) Anmeldenummer: **78101834.6**

(22) Anmeldetag: **23.12.78**

(54) **Verwendung einer amorphen Legierung aus Silicium und Germanium als gegen Galliumarsenid-Laserstrahlung empfindlichen Photoleiter.**

(30) Priorität: **13.01.78 US 869194**

(43) Veröffentlichungstag der Anmeldung:
**08.08.79 Patentblatt 79/16**

(45) Bekanntmachung des Hinweises auf die Patenterteilung:
**18.05.83 Patentblatt 83/20**

(84) Benannte Vertragsstaaten:
**DE FR GB NL**

(56) Entgegenhaltungen:
**US - A - 2 953 529**
**US - A - 3 105 906**

**SOLID STATE COMMUNICATIONS, Vol, 20, Nr, 19, December 1976, Oxford, GB, W. PAUL et al.: "Doping, Schottky barrier and p-n junction formation in amorphous germanium and silicon by rf sputtering", Seiten 969—972**
**Solid State Communications, Vol. 24, P. 867—869, 1977, J. CHEVALLIER et al.**

(73) Patentinhaber: **International Business Machines Corporation**
**Armonk, N.Y. 10504 (US)**

(72) Erfinder: **Chevallier, Jacques Paul**
**14, Allee du Bourbonnais**
**F-78310 Maurepas (FR)**
Erfinder: **Guarnieri, Charles Richard**
**113 Winsted Crt.**
**San Jose Californien 95139 (US)**
Erfinder: **Onton, Aare**
**14690 Aloha Ave.**
**Saratoga Californien 95070 (US)**
Erfinder: **Wieder, Harold**
**20175 Knollwood Drive**
**Saratoga Californien 95070 (US)**

(74) Vertreter: **Kreidler, Eva-Maria, Dr. rer. nat.**
**Schönaicher Strasse 220**
**D-7030 Böblingen (DE)**

Verwendung einer amorphen Legierung aus Silicium und Germanium als gegen Galliumarsenid-Laserstrahlung empfindlichen Photoleiter

Die Erfindung betrifft die Verwendung einer amorphen Legierung aus Silicium und Germanium mit einem Gehalt an Wasserstoff als gegen Galliumarsenid-Laserstrahlung empfindlichen Photoleiter.

Gegen Infrarotstrahlung empfindliche Photoleiter mit einem hohen Dunkelwiderstand und schnellen Ansprechzeiten sind interessant für Anwendungen in Vorrichtungen, die mit hoher Geschwindigkeit durch Strahlung activiert werden. Insbesondere sind Photoleiter erwünscht, welche gegen Strahlung eines Galliumarsenid-Lasers, dessen Maximum der emittierten Energie bei etwa 1,5 eV liegt, empfindlich sind.

Die Herstellung amorphen Siliciums und amorphen Germaniums in einem Glimmentladungsverfahren wurde von Chittick in Journal of Non-crystalline Solids, Band 3, (1970), Seiten 255 bis 270 beschrieben. Chittick gab an, daß amorphes Silicium mit einem Gehalt an Wasserstoff, der durch das Herstellungsverfahren der Glimmentladung bedingt war, ein sehr guter Photoleiter in dem Spektralgebiet von etwa 2 eV war. Die Photoleitfähigkeit sank jedoch im beträchtlichem Maße ab bei Werten unterhalb 2 eV und war bei 1,5 eV, der Wellenlänge des Galliumarsenid-Lasers verhältnismäßig schwach. Chittick gab auch an, daß amorphes Germanium, welches nach dem gleichen Verfahren hergestellt wurde und Wasserstoff enthielt, keine meßbare Photoleitfähigkeit und einen niedrigen Dunkelwiderstand aufwies.

Kristalline Silicium-Germaniumlegierungen sind nach einem Verfahren hergestellt worden, das von Braunstein in Physical Review, Band 130 (1963), Seite 869 beschrieben ist, Auch diese Legierungen zeigen keine meßbare Photoleitfähigkeit.

Beaglehole gab in Journal of Non-Crystalline Solids, Band 4 (1970), Seite 272 an, daß amorphe Silicium-Germaniumlegierungen, welche durch gemeinsame Verdampfung hergestellt worden waren, keine beobachtbare Photoleitfähigkeit aufwiesen. Die amorphen Silicium-Germaniumlegierungen, die nach diesem Verfahren hergestellt worden waren, enthielten auf Grund ihrer Herstellungsmethode keinen Wasserstoff.

J. Chevallier et al beschreiben in Solid State Comm., Vol. 24, Seiten 867 bis 869, 1977 die optischen Eigenschaften von amorphen $Si_xGe_{1-x}(H)$-Legierungen. Sie geben für die Abhängigkeit der optischen Absorptionskante von der Legierungszusammensetzung eine lineare Beziehung $E_o=0,95+0,70x(eV)$ an. Die Photoleitfähigkeit der Legierungen ist in dieser Veröffentlichung nicht beschrieben.

Aufgabe der Erfindung ist die Verwendung der zuvor beschriebenen amorphen Legierungen als Photoleiter, der eine verbesserte Strahlungsempfindlichkeit im Infrarotspektralbereich aufweist.

Der Photoleiter soll gegen Strahlung eines Galliumarsenid-Lasers bei 1,5 eV empfindlich sein. Außerdem soll dieser Photoleiter eine kurze Ansprechzeit und einen hohen Dunkelwiderstand aufweisen.

Die Aufgabe der Erfindung wird gelöst durch einen Photoleiter, dessen Zusammensetzung in den Patentansprüchen angegeben ist.

Der Photoleiter besteht aus einer amorphen $Si_xA_{1-y}H_y$-Legierung, in der A Ge, Sn oder Pb ist und x=0,50 bis 0,99 und y=1 bis 50 Atomprozent bedeuten. Eine Zusammensetzung eines bevorzugten Ausführungsbeispiels ist amorphes $Si_xGe_{1-x}H_y$, in dem x ein Bereich von 0,78 bis 0,93 und y einen Bereich von 14 bis 22 Atomprozent abdeckt. Dieses Material ist bei 1,5 eV ein sehr guter Photoleiter und weist einen hohen Dunkelwiderstand von etwa $10^8$ Ohm×cm und eine schnelle Ansprechzeit, d.h. eine Beweglichkeit von $5×10^{-2}$ cm²/Vs auf.

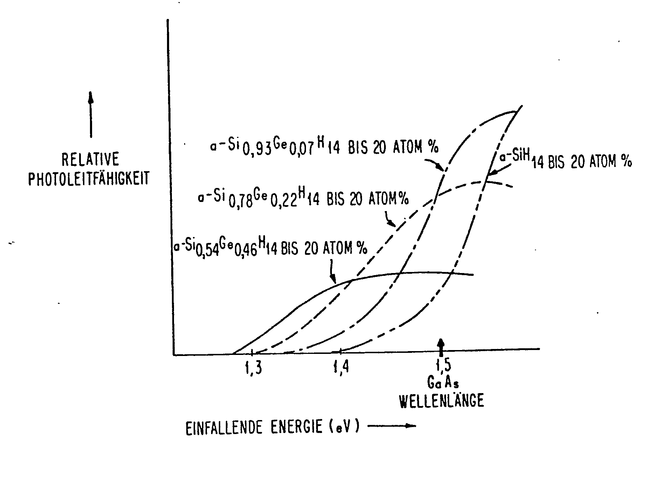

Die Erfindung wird anhand von Fig. 1 und der nachfolgenden detaillierten Beschreibung näher erläutert.

Fig. 1 zeigt die Abhängigkeit der Photoleitfähigkeit in der Umgebung der Absorptionskante von der einfallenden Wellenlänge für drei Zusammensetzungen des Photoleiters, verglichen mit amorphem Silicium mit einem vergleichbaren Gehalt an Wasserstoff.

Gemäß der vorliegenden Erfindung besteht ein verbesserter Photoleiter für mit Galliumarsenid-Laserstrahlung adressierbare Geräte, der gegenüber Strahlung bei etwa 1,5 eV empfindlich ist, aus amorphem Material mit einem Gehalt an Silicium, Wasserstoff und einem Material aus der Gruppe von Germanium, Zinn und Blei. Die allgemeine Formel dieser amorphen Legierung ist $Si_xA_{1-x}H_y$, in der A Ge, Sn oder Pb ist und x=0,50 bis 0,99 und y=1 bis 50 Atomprozent bedeuten.

In einem bevorzugten Ausführungsbeispiel enthält die amorphe Siliciumlegierung Germanium. Ein bevorzugter Konzentrationsbereich für Germanium ist gegeben, wenn x zwischen 0,78 und 0,93 liegt. Durch Zugabe von Germanium, Zinn oder Blei, beispeilsweise von Germanium, wird die Absorptionskante des amorphen Siliciums weiter in den infraroten Spektralbereich verschoben, ohne daß die Ansprechzeit und der Dunkelwiderstand, welche mit amorphem Silicium allein erhalten werden, nachteilig beeinflußt werden, so daß eine Empfindlichkeit auf Galliumarsenid-Laserstrahlung bei 1,5 eV erhalten wird.

Die amorphen Legierungen können durch Glimmentladung oder alternativ in einem Kathodenzerstäubungssystem hergestellt werden, wobei die entsprechenden Elemente in einem Trägergas aus Wasserstoff enthalten sind. Beide Verfahren sind an sich bekannt. Eine amorphe Legierung aus Si-GeH wird hergestellt, indem gleichzeitig Silan und German in die Reaktionskammer des Glimmentladungsverfahrens eingefüllt werden.

**Beispiel 1**

Ein Film mit einer Schichtdicke von 1 bis 3 $\mu$m aus amorphem $Si_xGe_{1-x}H_y$, in dem x 0,93 ist und y zwischen 14 und 20 Atomprozent liegt, wurde durch eine Hochfrequenz-Glimmentladungszersetzung von gasförmigem Silan und German erhalten. Die gemischten Gase wurden bei einem Druck von 41,23 Pa umgesetzt, die Fließgeschwindigkeit betrug 0,6 (Scm³/s) (S=Standard) une eine Hochfrequenzenergie von etwa 24 Watt wurde angewendet. Die Substrattemperatur war konstant und lag bei etwa 250°C. In diesem Glimmentladungsverfahren ist Wasserstoff anwesend. Die Photoleitfähigkeit, die die Verschiebung der Absorptionskante weiter in den infraroten Spektralbereich zeigt, ist aus Fig. 1 ersichtlich, in der sie mit einer amorphen Siliciumlegierung verglichen wird, in der eine ähnliche Menge Wasserstoff eingebaut ist.

**Beispiele 2 und 3**

Filme mit einem Germaniumgehalt, bei denen x in der Formel 0,78 und 0,54 bedeutet, wurden nach dem in Beispiel 1 angegebenen Verfahren hergestellt. Die Photoleitfähigkeit dieser beiden Materialien ist ebenfalls in Fig. 1 eingetragen.

Wie in Fig. 1 gezeigt ist, zeigen alle drei Legierungen der Beispiele 1, 2 und 3 eine Verschiebung der Absorptionskante weiter in den infraroten Spektralbereich. Diese wird erhalten, ohne daß der Dunkelwiderstand oder die Ansprechzeit des Materials nachteilig beeinflußt werden. Die drei angegebenen Legierungen weisen eine Empfindlichkeit gegen Galliumarsenid-Laserstrahlung bei 1,5 eV auf, die wesentlich größer ist als die eines amorphen Siliciums, das nur Wasserstoff enthält.

**Patentansprüche**

1. Verwendung einer amorphen Legierung der allgemeinen Formel $Si_xA_{1-x}H_y$, in der A Ge, Sn oder Pb ist und x 0,50 bis 0,99 und y 1 bis 50 Atom% bedeuten als Photoleiter, der gegen Galliumarsenid-Laserstrahlung empfindlich ist.

2. Verwendung einer Legierung nach Anspruch 1, in der A germanium ist, als Photoleiter.

3. Verwendung einer Legierung nach Anspruch 1, in der x 0,78 bis 0,93 und y 14 bis 20 Atom% bedeuten, als Photoleiter.

**Claims**

1. Use of an amorphous alloy of the general formula $Si_xA_{1-x}H_y$, where A is Ge, Sn or Pb, and where x is 0.50 to 0.99, and where y is 1 to 50 atomic percent, as a photoconductor sensitive to illumination from a gallium arsenide laser.

2. Use of an alloy as claimed in claim 1, where A is germanium, as photoconductor.

3. Use of an alloy as claimed in claim 1, where x equals 0.78 to 0.93, and y equals 14 to 20 atomic percent, as a photoconductor.

**Revendications**

1. Utilisation d'un alliage amorphe dont la formule générale est la suivante: $Si_xA_{1-x}H_y$, dans laquelle A est du Ge, du Sn ou du Pb et dans laquelle x est compris entre 0,50 et 0,99, et dans laquelle y est compris entre 1 et 50 en pourcentage atomique, en tant que photoconducteur sensible au rayonnement émis par un laser à l'arséniure de gallium.

2. Utilisation d'un alliage selon la revendication 1 dans lequel A est du germanium, en tant que photoconducteur.

3. Utilisation d'un alliage selon la revendication 1, dans lequel x est compris entre 0,78 et 0,93 et y compris entre 14 et 20 en pourcentage atomique, en tant que photoconducteur.